# FASCICULE DE BREVET EUROPEEN

(11) **EP 3 383 150 B1**
(45) Date de publication et mention de la délivrance du brevet: **20.04.2022**
(21) Numéro de dépôt: 18163647.3
(22) Date de dépôt: 23.03.2018
(51) Int. Cl.: H05K 3/40, H01R 12/52, F21S 41/148, F21S 41/151, F21S 41/19, H05K 3/34, F21S 45/47

(54) **DISPOSITIF D'ALIMENTATION ELECTRIQUE D'AU MOINS UNE LED ET D'AU MOINS UN COMPOSANT ELECTRONIQUE, COMPRENANT UN CIRCUIT DE PILOTAGE DE L'ALIMENTATION ELECTRIQUE MUNI D'UN INSERT**
STROMVERSORGUNGSVORRICHTUNG FÜR MINDESTENS EINE LED UND MINDESTENS EIN ELEKTRONISCHES BAUELEMENT, MIT EINER EIN INSERT ENTHALTENDEN STROMVERSORGUNGSSTEUERSCHALTUNG
POWER SUPPLY DEVICE FOR AT LEAST ONE LED AND AT LEAST ONE ELECTRONIC COMPONENT, COMPRISING A POWER SUPPLY CONTROL CIRCUIT PROVIDED WITH AN INSERT

(30) Priorité: 31.03.2017 FR 1752753
(43) Date de publication de la demande: 03.10.2018
(73) Titulaire: Valeo Iluminacion, 23600 Martos (ES)
(72) Inventeur: ROLDAN, Jose-David, 23600 MARTOS (ES); ILLAN, Antonio Domingo, 23600 MARTOS (ES); PENA, Miguel-Angel, 23600 MARTOS (ES)
(74) Mandataire: Valeo Visibility

(56) Documents cités:
- DE-A1-102011 101 805
- US-A1- 2016 281 946
- US-A1- 2016 290 589
- US-B1- 6 333 471
- US-B1- 6 747 217

## Description

La présente invention se rapporte au domaine des dispositifs d'alimentation électrique d'au moins une source lumineuse et d'au moins un composant électronique. En particulier la présente invention a trait à un dispositif d'alimentation électrique comprenant un circuit de pilotage de l'alimentation électrique de la ou chaque source lumineuse, le circuit de pilotage comprenant au moins une piste conductrice électriquement. En particulier, mais non exclusivement, la ou chaque source lumineuse peut être une diode électroluminescente. L'invention vise également un support de source(s) lumineuse(s) pour module d'éclairage et/ou de signalisation lumineuse pour véhicule automobile comprenant un tel dispositif d'alimentation électrique ; un module d'éclairage pour véhicule automobile comprenant un tel support de source(s) lumineuse(s) ; ainsi qu'un dispositif lumineux de véhicule comprenant un tel support de source(s) lumineuse(s) et/ou un tel module d'éclairage.

On connaît des dispositifs d'alimentation électrique d'au moins une source lumineuse et d'au moins un composant électronique, comprenant un circuit de pilotage de l'alimentation électrique de la ou chaque source lumineuse. Le circuit de pilotage comprend au moins une piste conductrice électriquement. De tels dispositifs permettent d'alimenter conjointement en courant électrique la source lumineuse et le composant électronique.

Le composant électronique peut par exemple être une autre source lumineuse, par exemple du type diode électroluminescente, mais également tout autre type de composant électronique.

Lorsque la source lumineuse et le composant électronique sont agencés de part et d'autre d'un composant tiers, tel que par exemple un dissipateur thermique, comme c'est le cas par exemple dans un module d'éclairage pour véhicule automobile à bi-faisceaux, se pose le problème de l'efficacité de l'alimentation électrique de la source lumineuse et du composant électronique, ainsi que celui de l'encombrement des moyens d'alimentation électrique.

Afin de répondre à ce double problème, il est connu de prévoir un circuit de pilotage de l'alimentation électrique préalablement plié, de sorte à pouvoir être fixé de part et d'autre du composant tiers. Par exemple, lorsque le composant tiers est un substrat de dissipation thermique présentant deux faces opposées, le circuit de pilotage préalablement plié est fixé sur chaque face opposée du dissipateur thermique, de sorte à présenter au moins une piste conductrice électriquement de part et d'autre du substrat. La source lumineuse et le composant électronique, par exemple fixés respectivement sur chaque face opposée du substrat, sont ensuite reliés électriquement au circuit de pilotage, plus précisément à la ou une des piste(s) conductrice(s) du circuit de pilotage.

Un inconvénient d'un tel dispositif d'alimentation électrique est que le circuit de pilotage préalablement plié est relativement coûteux et peu fiable. En effet, le rapport surface utile sur volume total du circuit de pilotage est relativement faible, ce qui induit des surcoûts substantiels. En outre, le pliage du circuit de pilotage nécessite un usinage préalable, ce qui induit là encore des coûts additionnels. Enfin, des risques de cassure importants existent au niveau des lignes de pliage du circuit de pilotage.

Le document DE 10 2011 101805 A1 décrit un dispositif d'alimentation électrique connu de l'homme du métier. Le document US 2016/281946 A1 décrit un support de source(s) lumineuse(s) qui est compatible avec le dispositif d'alimentation électrique connu du document DE 10 2011 101805 A1. Enfin, le document US 2016/290589 A1 décrit un module d'éclairage qui peut contenir le support de source(s) lumineuse(s) connu du document US 2016/281946 A1.

Le problème technique que vise à résoudre l'invention est donc de proposer un dispositif d'alimentation électrique d'au moins une source lumineuse et d'au moins un composant électronique, adapté pour alimenter conjointement en courant électrique la source lumineuse et le composant électronique lorsque ceux-ci sont agencés de part et d'autre d'un composant tiers, et présentant un encombrement et des coûts réduits et une fiabilité améliorée.

A cet effet, un premier objet de l'invention est un dispositif d'alimentation électrique tel que défini dans la revendication 1.

Ainsi, grâce à la présence de l'insert électriquement conducteur reçu dans le logement de réception du circuit de pilotage, et connecté électriquement à la piste conductrice, un point d'accès à une alimentation électrique est obtenu du côté de la face opposée à la face du circuit de pilotage portant la piste conductrice. Aucun pliage du circuit de pilotage n'est alors nécessaire, ce qui diminue drastiquement les risques de cassure. En outre, un circuit de pilotage de coût moindre peut avantageusement être utilisé. On obtient ainsi une solution fiable, économique et peu encombrante pour l'alimentation électrique conjointe de la source lumineuse et du composant électronique.

Les matières de la deuxième partie d'extrémité permettent de réaliser une soudure pour liaison électrique par pontage. Avantageusement elle est réalisée sous la forme d'un placage sur le corps de l'insert.

Le dispositif d'alimentation électrique selon l'invention peut optionnellement présenter une ou plusieurs des caractéristiques suivantes :
- la première partie d'extrémité de l'insert est fixée par soudure sur la première face du circuit de pilotage ;
- l'insert est une pièce mécanique retenue par friction dans le logement de réception du circuit de pilotage ;
- la face extérieure de la première partie d'extrémité et la première face du circuit de pilotage affleurent ;
- l'insert est obtenu par moulage d'un matériau conducteur électriquement dans le logement de réception du circuit de pilotage ;
- le corps de l'insert est de préférence réalisé en aluminium ; il peut être cuivre, en étain, ou en aluminium ; ou encore dans un alliage comprenant au moins deux matériaux parmi le cuivre, l'étain et l'aluminium ;
- l'insert est formé de deux branches distinctes reliées entre elles ;
- la deuxième partie d'extrémité de l'insert présente une section transversale cylindrique, notamment une section transversale circulaire ou rectangulaire ;
- le circuit de pilotage de l'alimentation est imprimé sur ou dans un circuit imprimé en matériau isolant électriquement ;
- le circuit de pilotage comprend une plaque sur laquelle est montée la piste conductrice électriquement, préférentiellement une plaque en résine thermodurcissable renforcée de fibres solides.

L'invention a également pour objet un support de source(s) lumineuse(s) pour module d'éclairage et/ou de signalisation lumineuse pour véhicule automobile, tel que défini dans la revendication 4.

Selon un exemple de réalisation, le ou chaque composant électronique est un module de pilotage du courant au sein de la ou d'une des source(s) lumineuse(s).

Selon un autre exemple de réalisation, le ou chaque composant électronique est une source lumineuse du type diode électroluminescente.

Le support de source(s) lumineuse(s) selon l'invention peut optionnellement présenter une ou plusieurs des caractéristiques suivantes :
- la ou chaque source lumineuse est collée ou soudée sur la première face du substrat ;
- le circuit de pilotage de l'alimentation comprend un bord en vis-à-vis de la ou d'au moins une des sources lumineuses ;
- la ou chaque source lumineuse est collée ou soudée sur le circuit de pilotage ;
- la ou chaque source lumineuse est connectée à la ou une des piste(s) conductrice(s) du circuit de pilotage au moyen de fils métalliques soudés en surface
- le ou chaque composant électronique est connecté à la deuxième partie d'extrémité de l'insert au moyen de fils métalliques soudés en surface ;
- les fils métalliques s'étendent de manière aérienne, préférentiellement avec des profils de boucle, à distance des surfaces extérieures respectives du circuit de pilotage de l'alimentation et de la ou des source(s) lumineuse(s) ;
- le substrat comprend des ailettes de refroidissement ;
- le substrat comprend une première portion formant une paroi supportant la ou les source(s) lumineuse(s) et une deuxième portion comprenant les ailettes de refroidissement ;
- la deuxième portion est disposée essentiellement dans l'alignement de la première portion ;
- les première et deuxième portions du substrat sont venues de matière ;
- le substrat et le circuit de pilotage forment un seul et même composant de type substrat métallique isolé ;
- le substrat est en aluminium.

L'invention a également pour objet un module d'éclairage pour véhicule automobile, tel que défini dans la revendication 9.

Le module d'éclairage selon l'invention peut optionnellement présenter une ou plusieurs des caractéristiques suivantes :
- le module comprend un premier dispositif optique disposé en regard de la première face du substrat, et un deuxième dispositif optique disposé en regard de la deuxième face du substrat ;
- le substrat comprend des ailettes de refroidissement disposées en arrière du ou des dispositif(s) optique(s) par rapport à la direction principale d'émission du faisceau d'éclairage.

L'invention a également pour objet un dispositif lumineux de véhicule tel que défini dans la revendication 12.

Dans un mode de réalisation particulier de l'invention, le dispositif lumineux de véhicule selon l'invention est un dispositif d'éclairage de la route, notamment un projecteur.

D'autres caractéristiques et avantages de l'invention apparaîtront à la lecture de la description détaillée des exemples non limitatifs qui suivent, pour la compréhension de laquelle on se reportera aux dessins annexés, parmi lesquels :
- La figure 1 est une vue en perspective d'un dispositif lumineux de véhicule muni d'un module d'éclairage, le module d'éclairage comprenant un support de sources lumineuses, le support comportant deux sources lumineuses et un dispositif d'alimentation électrique des sources lumineuses selon l'invention ;
- La figure 2 est une vue en coupe, prise selon un plan II-II, du module d'éclairage de la figure 1 ;
- La figure 3 est une vue en perspective du dessus du support de sources lumineuses de la figure 1 selon un premier exemple de réalisation, le support comprenant un dispositif d'alimentation électrique selon un premier mode de réalisation de l'invention ;
- La figure 4 est une vue en perspective du dessous du support de sources lumineuses de la figure 3 ;
- La figure 5 est une vue en coupe, prise selon un plan V-V, du support de sources lumineuses de la figure 3 ;
- La figure 6 est une vue en perspective du dessus du support de sources lumineuses de la figure 1 selon un deuxième exemple de réalisation ;
- La figure 7 est une vue en perspective du dessus du support de sources lumineuses de la figure 1 selon un troisième exemple de réalisation, le support comprenant un dispositif d'alimentation électrique selon un deuxième mode de réalisation de l'invention ;
- La figure 8 est une vue en perspective du dessous du support de sources lumineuses de la figure 7 ;
- La figure 9 est une vue en coupe, prise selon un plan IX-IX, du support de sources lumineuses de la figure 7.

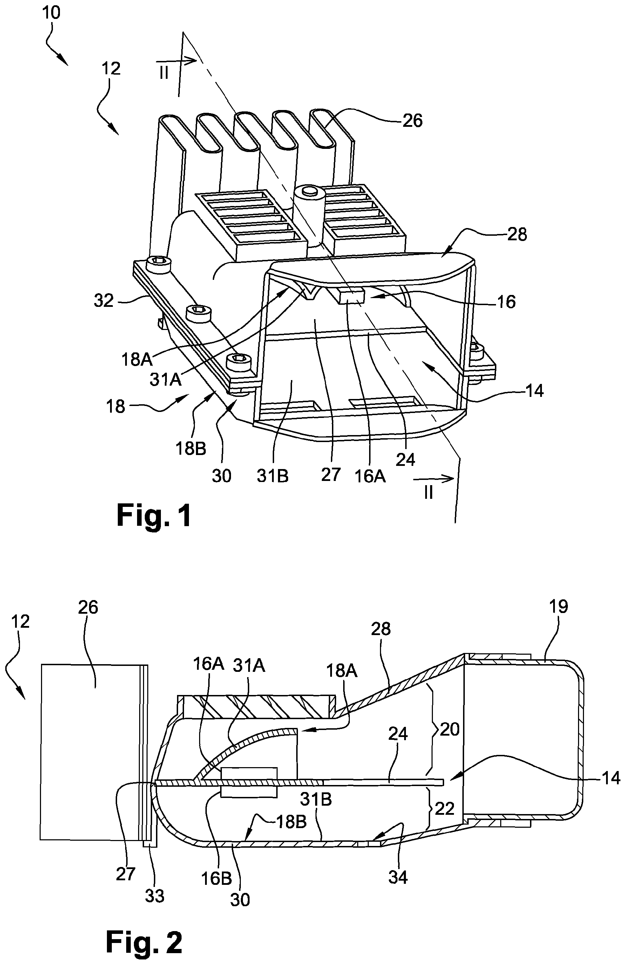

Les figures 1 et 2 illustrent un dispositif lumineux 10 de véhicule. Le dispositif lumineux 10 est un dispositif d'éclairage ou de signalisation de tout type, apte à éclairer ou à signaler la présence d'un objet ou d'une entité physique. Dans l'exemple de réalisation particulier des figures 1 et 2, le dispositif lumineux 10 est un dispositif d'éclairage de la route, notamment un projecteur. En variante non représentée, le dispositif lumineux 10 est un feu de signalisation d'un véhicule, ou encore un module de signalisation lumineuse agencé sur ou au sein d'un véhicule. Le dispositif lumineux 10 de véhicule comprend par exemple un module d'éclairage 12, comme illustré sur les figures 1 et 2.

Le module d'éclairage 12 pour véhicule comprend un support 14 de source(s) lumineuse(s) 16, et au moins un dispositif optique 18 apte à transmettre les rayons lumineux émis par la ou les source(s) lumineuse(s) 16 en un faisceau d'éclairage. De préférence, le module d'éclairage 12 comporte en outre un dispositif optique de projection 19.

Dans l'exemple de réalisation particulier des figures 1 et 2, le support 14 comprend deux sources lumineuses 16A, 16B, et le module d'éclairage 12 comprend deux dispositifs optiques 18A, 18B. Selon cet exemple de réalisation particulier, le module d'éclairage 12 est formé de deux sous-modules 20, 22, rapportés l'un contre l'autre.

Les deux sous-modules 20, 22 sont disposés l'un sous l'autre, de part et d'autre d'un substrat 24 central de support, qui sera décrit par la suite. Dans l'exemple de réalisation préférentiel illustré sur les figures 1 et 2, le substrat 24 porte à une extrémité des ailettes de refroidissement par échange thermique 26. De telles ailettes de refroidissement 26 forment, conjointement avec le substrat 24, un dissipateur thermique. Les ailettes de refroidissement 26 sont disposées vers l'arrière des dispositifs optiques 18A, 18B. Par " vers l'arrière des dispositifs optiques ", on entend dans le sens opposé à la direction principale d'émission du faisceau d'éclairage.

Dans l'exemple de réalisation préférentiel illustré sur les figures 1 et 2, le substrat 24 comprend une première portion 27 et une deuxième portion 33. La première portion 27 forme une paroi supportant les sources lumineuses 16A, 16B. La deuxième portion 33 comprend les ailettes de refroidissement 26. De préférence, comme illustré sur la figure 2, les première et deuxième portions 27, 33 sont venues de matière.

Chaque sous-module 20, 22 comporte une demi-coque 28, 30 qui est fixée sur le substrat 24. Chaque source lumineuse 16A, 16B est disposée sur la face du substrat 24 qui est tournée vers la demi-coque 28, 30 correspondante de manière à pouvoir émettre des rayons lumineux vers cette demi-coque.

Chaque dispositif optique 18A, 18B est par exemple formé d'un élément de déviation optique 31A, 31B, et est disposé en regard de la face du substrat 24 qui est tournée vers la demi-coque 28, 30 correspondante.

Le dispositif optique de projection 19 est porté par les extrémités libres des demi-coques 28, 30, l'ensemble étant agencé de sorte que pour chaque sous-module 20, 22, les rayons émis par les sources lumineuses 18A, 18B sont réfléchis par le dispositif optique 18A, 18B associé, en direction du dispositif optique de projection 19. Ici le dispositif optique de projection 19 est une lentille de projection.

On va décrire dans la suite les demi-coques en fonction de l'orientation du module d'éclairage 12 illustré notamment sur la figure 1, dans laquelle une deuxième demi-coque 28 est disposée au-dessus d'une première demi-coque 30, de sorte que l'on assimilera pour l'exemple qui va suivre les notions de première demi-coque et de demi-coque inférieure, ainsi que celles de deuxième demi-coque et de demi-coque supérieure.

La première demi-coque 30 ou demi-coque inférieure est par exemple réalisée dans un matériau plastique de type polycarbonate, et elle comporte à sa périphérie un cadre 32 de fixation au substrat 24, et en son centre une paroi courbe présentant un profil sensiblement ellipsoïde, non visible sur les figures. La première demi-coque 30 loge à l'intérieur du dôme ainsi formé entre la demi-coque et le substrat 24 une source lumineuse 16B formée par une diode électroluminescente rapportée sous le substrat 24. On comprend que, si la première demi-coque 30 présente un profil ellipsoïde double, on prévoira deux sources lumineuses 16B spécifiques pour que chaque ellipsoïde soit éclairé spécifiquement par la diode de l'une des sources.

L'élément de déviation optique 31B est réalisé directement par une partie de la surface interne 34 de la première demi-coque 30. Un revêtement spécifique de la surface interne 34 est réalisé dans un matériau réfléchissant, sur tout ou partie de la première demi-coque 30.

La source lumineuse 16B et l'élément de déviation optique 31B sont agencés de sorte que les rayons émis par la source 16B sont déviés par la surface réfléchissante en direction du dispositif optique de projection 19, de manière à former un faisceau d'éclairage de type feu de route.

La deuxième demi-coque 28 ou demi-coque supérieure est par exemple réalisée dans un matériau plastique de type polycarbonate. La deuxième demi-coque 28 fait partie d'un sous-module supérieur 20 apte à générer en sortie un faisceau de type feux de croisement.

Dans le mode de réalisation décrit, l'élément de déviation optique 31A est réalisé indépendamment de la deuxième demi-coque 28. Celle-ci est fixée sur le substrat 24 de manière à venir en recouvrement de l'élément de déviation optique 31A formé par un réflecteur lui aussi fixé sur le substrat 24.

Le réflecteur 31A présente une face interne dont le revêtement est apte à réfléchir la lumière émise par la source lumineuse 16A en regard de laquelle il est disposé. La source lumineuse 16A est par exemple formée d'une diode électroluminescente rapportée sur le substrat 24. Tel qu'illustré, le réflecteur 31A peut être double c'est-à-dire qu'il peut présenter une forme à plusieurs ellipses, et dans ce cas il est prévu une source lumineuse 16A spécifique pour chaque forme elliptique du réflecteur 31A.

Les rayons émis par la source lumineuse 16A sont réfléchis par le réflecteur 31A en direction du dispositif optique de projection 19, et un cache est disposé sur le trajet des rayons de sorte que le faisceau soit coupé et que la lumière en sortie forme des feux de croisement non éblouissant pour les autres usagers.

En variante non représentée, on pourra prévoir que la deuxième demi-coque 28 est réalisée sensiblement comme la première demi-coque 30, avec une pièce unique qui joue le rôle de coque et de surface réfléchissante par traitement de sa surface interne.

Les diodes électroluminescentes formant les sources lumineuses 16A, 16B sont avantageusement des diodes de puissance montées sur embase en matériau céramique. Elles sont dépourvues de plaque métallique du coté de la face de montage de l'embase. Ces diodes électroluminescentes sont donc constituées d'un composant semi-conducteur électroluminescent placé sur l'embase, avec des moyens qui permettent l'alimentation électrique du composant semi-conducteur tels que des microbilles en or, une couche de soudure en or ou un fil en or. Ces diodes électroluminescentes sur embase céramique permettent une meilleure gestion des contraintes thermiques et surtout une précision accrue de positionnement vis-à-vis d'un dispositif optique 18A, 18B destiné à transmettre la lumière émise par ces diodes, par rapport à d'autres types de conditionnement (package) de diodes électroluminescentes, qui sont plus encombrants et ont une embase avec une surface plus étendue, comportant habituellement une plaque métallique, généralement en cuivre ou aluminium, du coté de la face de contact avec le support.

Le support 14 comprend le substrat 24, au moins une source lumineuse 16A et au moins un composant électronique. Le support 14 comprend en outre un dispositif d'alimentation électrique de la ou chaque source lumineuse 16A et du ou de chaque composant électronique.

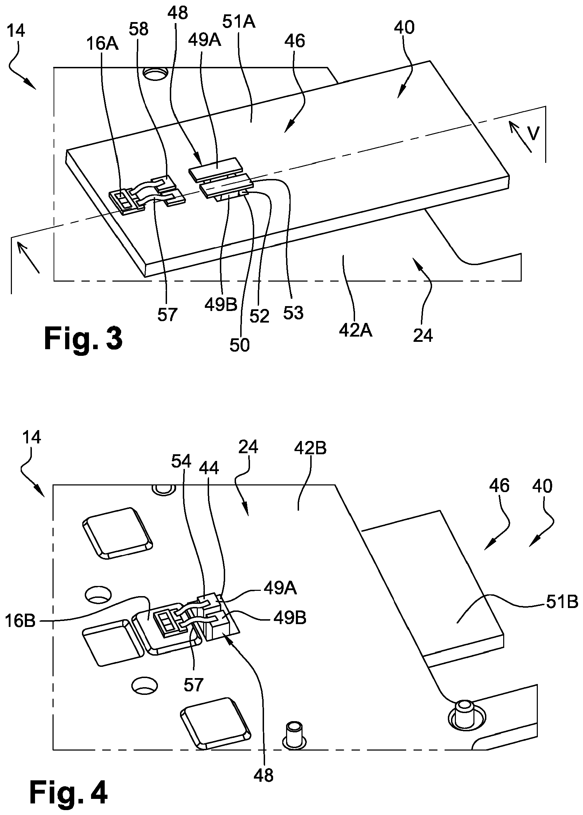

Le support 14 de source(s) lumineuse(s) selon un premier exemple de réalisation va maintenant être décrit plus en détail, en référence aux figures 3 à 5.

Le support 14 comprend une seule source lumineuse 16A, un seul composant électronique, et un dispositif d'alimentation électrique 40 selon un premier mode de réalisation de l'invention.

Le substrat 24 est en matériau conducteur thermiquement, par exemple en aluminium. Le substrat 24 comprend deux faces opposées 42A, 42B ; et un orifice 44 reliant les deux faces 42A, 42B.

Comme indiqué précédemment, la source lumineuse 16A est formée par une diode électroluminescente et est montée sur une première face 42A du substrat 24.

Le composant électronique est monté sur une deuxième face 42B du substrat 24, opposée à la première face 42A. De préférence, le composant électronique est fixé directement sur la deuxième face 42B du substrat 24, par exemple par collage ou par soudure. Dans l'exemple de réalisation particulier des figures 3 à 5, le composant électronique est la source lumineuse 16B, formée d'une diode électroluminescente.

Le dispositif d'alimentation électrique 40 comprend un circuit 46 de pilotage de l'alimentation électrique de la source lumineuse 16A, et un insert 48.

Le circuit de pilotage 46 comprend un logement 50 de réception de l'insert 48, et au moins une piste conductrice électriquement, non représentée sur les figures pour des raisons de clarté. De préférence, le circuit de pilotage 46 est imprimé sur un circuit imprimé en matériau isolant électriquement. En variante, le circuit de pilotage 46 est imprimé dans un tel circuit imprimé. De préférence encore, le circuit de pilotage 46 comprend une plaque sur laquelle est montée la piste conductrice électriquement. La plaque est préférentiellement une plaque en résine thermodurcissable renforcée de fibres solides.

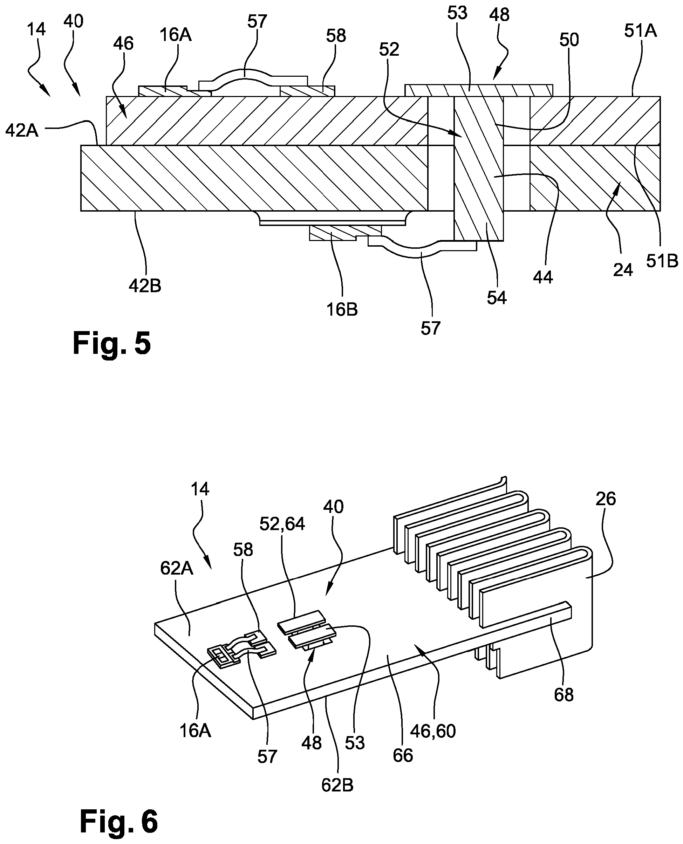

Le circuit de pilotage 46 est agencé sur la première face 42A du substrat 24 de sorte à ce que le logement de réception 50 s'étende en regard de l'orifice 44, comme illustré sur la figure 5.

Selon le mode de réalisation particulier du dispositif d'alimentation 40 représenté aux figures 3 à 5, le circuit de pilotage 46 comprend une première face 51A, une deuxième face 51B opposée à la première face 51A, et une ouverture 52 reliant de part en part les première et deuxième faces 51A, 51B. La piste conductrice électriquement du circuit de pilotage 46 est agencée sur la première face 51A. L'ouverture 52 forme le logement 50 de réception de l'insert 48, comme illustré sur la figure 5.

L'insert 48 est en matériau conducteur électriquement. L'insert 48 est inséré dans le logement de réception 50 et s'étend au travers de l'orifice 44, comme illustré sur les figures 3 à 5. L'insert 48 comprend une première partie d'extrémité 53 et une deuxième partie d'extrémité 54. L'insert 48 est formé d'au moins une branche 49A, 49B présentant une forme en « T ». De préférence, comme illustré sur les figures 3 et 4, l'insert 48 est formé de deux branches distinctes 49A, 49B, reliées entre elles et présentant par exemple chacune une forme en « T ».

Selon le mode de réalisation particulier du dispositif d'alimentation 40 représenté aux figures 3 à 5, l'insert 48 s'étend en outre au travers de l'ouverture 52. Plus précisément, selon ce mode de réalisation particulier, la première partie d'extrémité 53 de l'insert 48 débouche du côté de la première face 51A du circuit de pilotage 46, et la deuxième partie d'extrémité 54 débouche du côté de la deuxième face 51B. La première partie d'extrémité 53 de l'insert 48 s'étend par exemple sur la première face 51A du circuit de pilotage 46, comme illustré sur les figures 3 et 5. Dans ce cas, la première partie d'extrémité 53 est par exemple fixée par soudure sur la première face 51A du circuit de pilotage 46. En variante de réalisation non représentée, la face extérieure de la première partie d'extrémité 53 de l'insert 48 et la première face 51A du circuit de pilotage 46 affleurent. Selon cette variante, l'insert 48 est une pièce mécanique retenue par friction dans le logement de réception 50. Cette variante permet de réduire les coûts de fabrication de l'insert 48.

Lorsque l'insert 48 est formé d'au moins une branche 49A, 49B présentant une forme en « T », la première partie d'extrémité 53 forme par exemple la barre la plus courte de la ou chaque branche en « T » 49A, 49B, comme illustré sur les figures 3 et 5. La deuxième partie d'extrémité 54 forme alors l'extrémité libre de la barre la plus longue de la ou chaque branche en « T » 49A, 49B. La première partie d'extrémité 53 est par exemple en cuivre. En variante, la première partie d'extrémité 53 est en étain ou en aluminium ; ou encore dans un alliage comprenant au moins deux matériaux parmi le cuivre, l'étain et l'aluminium. La deuxième partie d'extrémité 54 est nickel, en alliage nickel-or ou nickel-palladium ; avantageusement elle est réalisée sous la forme d'un placage sur le corps de l'insert.

La première partie d'extrémité 53 est électriquement reliée à la ou une des piste(s) conductrice(s) du circuit de pilotage 46, par exemple par contact électrique direct.

La deuxième partie d'extrémité 54 est connectée au composant électronique 16B pour l'alimentation électrique du composant 16B, comme illustré sur les figures 4 et 5. De préférence, comme illustré sur ces figures, le composant électronique 16B est connecté à la deuxième partie d'extrémité 54 au moyen de fils métalliques 57, par exemple au nombre de deux, soudés en surface de l'insert 48. De préférence encore, les fils métalliques 57 présentent des profils de boucle et s'étendent de manière aérienne à distance de la surface extérieure du circuit de pilotage 46. Ces fils 57 sont soudés à la deuxième partie d'extrémité 54 de l'insert 48, et aux zones correspondantes du composant électronique 16B, notamment par ultrasons. Il s'agit de la technologie communément désignée par l'expression anglo-saxonne «wire-bonding», ou encore par l'expression «câblage par fil» ou « pontage ». Le câblage est simplement réalisé par un fil (ou pont) soudé entre les deux éléments à ponter. La soudure est généralement réalisée par ultrasons. Le matériau du fil est de l'aluminium, de l'or ou du cuivre ou une combinaison de ces matériaux. Un seul ou plusieurs fils peuvent être utilisés pour chaque connexion. En variante non représentée, les fils métalliques 57 sont remplacés par des tresses métalliques ou par des languettes métalliques soudées en surface.

De préférence, la deuxième partie d'extrémité 54 présente une section transversale cylindrique. Dans l'exemple de réalisation des figures 3 à 5, la deuxième partie d'extrémité 54 présente une section transversale rectangulaire. Plus précisément, selon cet exemple de réalisation particulier, chaque partie de branche en « T » 49A, 49B qui forme une partie de la deuxième partie d'extrémité 54 présente une section transversale rectangulaire. En variante non représentée, la deuxième partie d'extrémité 54 présente une section transversale circulaire.

Dans l'exemple de réalisation particulier des figures 3 à 5, la source lumineuse 16A est fixée directement sur le circuit de pilotage 46, par exemple par collage ou par soudure. La source lumineuse 16A est connectée à la ou une des piste(s) conductrice(s) du circuit de pilotage 46. De préférence, comme illustré sur les figures 3 et 5, la source lumineuse 16A est connectée à la ou une des piste(s) conductrice(s) du circuit de pilotage 46 au moyen de fils métalliques 57, par exemple au nombre de deux, soudés en surface du circuit 46 via des plots de connexion métalliques 58. La soudure des fils métalliques 57 aux plots de connexion 58 et aux zones correspondantes de la source lumineuse 16A est avantageusement réalisée via une technologie de «câblage par fil» ou « pontage », telle qu'exposée ci-dessus. De préférence, les fils métalliques 57 présentent des profils de boucle et s'étendent de manière aérienne à distance de la surface extérieure du circuit de pilotage 46. En variante non représentée, les fils métalliques 57 sont remplacés par des tresses métalliques ou par des languettes métalliques soudées en surface.

La technologie de connexion par pontage avec des fils métalliques soudés, préférentiellement par ultrasons mais aussi par soudure laser ou soudure électro-résistive, permet de réaliser ensuite les connexions électriques de manière simple, fiable, économique, et compatible avec la fixation par colle ou par soudure des sources lumineuses ou des composants électroniques.

Le support 14 de source(s) lumineuse(s) selon un deuxième exemple de réalisation va maintenant être décrit, en référence à la figure 6. Les éléments analogues au premier exemple de réalisation, décrit précédemment en regard des figures 3 à 5, sont repérés par des références identiques, et ne sont donc pas décrits à nouveau.

Le support 14 comprend la source lumineuse 16A, le composant électronique, et le dispositif d'alimentation électrique 40 selon le premier mode de réalisation de l'invention. Le support 14 comprend en outre un substrat 60.

Le substrat 60 est en matériau conducteur thermiquement. Le substrat 60 comprend deux faces opposées 62A, 62B ; et un orifice 64 reliant les deux faces 62A, 62B.

Le substrat 60 comprend en outre une première portion 66 et une deuxième portion 68. La première portion 66 forme une paroi supportant la source lumineuse 16A. La deuxième portion 68 comprend des ailettes de refroidissement 26. De préférence, comme illustré sur la figure 6, la deuxième portion 68 est disposée essentiellement dans l'alignement de la première portion 66. De préférence encore, les première et deuxième portions 66, 68 sont venues de matière.

Dans le support 14 de source(s) lumineuse(s) selon le deuxième exemple de réalisation de l'invention, le substrat 60 et le circuit de pilotage 46 forment un seul et même composant de type substrat métallique isolé. Ainsi, selon cet exemple de réalisation, l'orifice 64 et l'ouverture 52 sont confondus, comme illustré sur la figure 6.

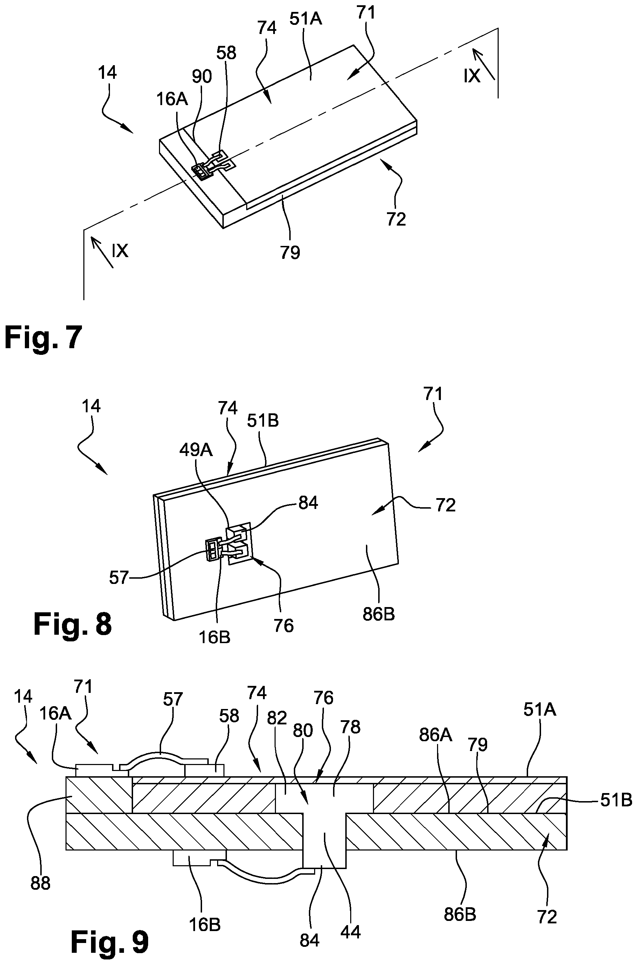

Le support 14 de source(s) lumineuse(s) selon un troisième exemple de réalisation va maintenant être décrit, en référence aux figures 7 à 9. Les éléments analogues au premier exemple de réalisation, décrit précédemment en regard des figures 3 à 5, sont repérés par des références identiques, et ne sont donc pas décrits à nouveau.

Le support 14 comprend la source lumineuse 16A, le composant électronique, et un dispositif 71 d'alimentation électrique de la source lumineuse 16A et du composant électronique selon un deuxième mode de réalisation de l'invention. Le support 14 comprend en outre un substrat 72.

Dans l'exemple de réalisation particulier des figures 7 à 9, le composant électronique est la source lumineuse 16B, formée d'une diode électroluminescente.

Le dispositif d'alimentation électrique 71 comprend un circuit 74 de pilotage de l'alimentation électrique de la source lumineuse 16A, et un insert 76.

Le circuit de pilotage 74 comprend un logement 78 de réception de l'insert 76, représenté à la figure 9, et au moins une piste conductrice électriquement, non représentée sur les figures pour des raisons de clarté. De préférence, le circuit de pilotage 74 est imprimé sur un circuit imprimé en matériau isolant électriquement. En variante, le circuit de pilotage 74 est imprimé dans un tel circuit imprimé. De préférence encore, le circuit de pilotage 74 comprend une plaque sur laquelle est montée la piste conductrice électriquement. La plaque est préférentiellement une plaque en résine thermodurcissable renforcée de fibres solides.

Le circuit de pilotage 74 est agencé dans un évidement 79 ménagé dans une des faces du substrat 72, comme décrit par la suite. Ainsi, le logement de réception 78 s'étend en regard de l'orifice 44, comme illustré sur la figure 9.

Selon le mode de réalisation particulier du dispositif d'alimentation 71 représenté aux figures 7 à 9, le circuit de pilotage 74 comprend une première face 51A, et une deuxième face 51B opposée à la première face 51A, et un trou borgne 80 ménagé dans la deuxième face 51B. La piste conductrice électriquement du circuit de pilotage 74 est agencée sur la première face 51A. Le trou borgne 80 forme le logement 78 de réception de l'insert 76.

L'insert 76 est en matériau conducteur électriquement et s'étend au travers de l'orifice 44 du substrat 72 reliant les deux faces opposées du substrat 72, comme illustré sur la figure 9 et comme décrit par la suite. L'insert 76 comprend une première partie d'extrémité 82 et une deuxième partie d'extrémité 84. L'insert 76 est par exemple formé d'au moins une branche 49A, 49B présentant une forme en « T ». De préférence, comme illustré sur la figure 8, l'insert 76 est formé de deux branches distinctes 49A, 49B, reliées entre elles et présentant par exemple chacune une forme en « T ».

Selon le mode de réalisation particulier du dispositif d'alimentation 71 représenté aux figures 7 à 9, l'insert 76 est une pièce mécanique retenue par friction dans le logement de réception 78, comme illustré sur la figure 9. De préférence, le corps de l'insert 76 est obtenu par moulage d'un matériau conducteur électriquement, par exemple de l'aluminium, dans le logement de réception 78.

Selon ce mode de réalisation particulier des figures 7 à 9, la première partie d'extrémité 82 de l'insert 48 est en contact électrique avec la ou une des piste(s) conductrice(s) du circuit de pilotage 74. Dans l'exemple illustratif de la figure 9, la première partie d'extrémité 82 de l'insert 48 est en contact électrique direct avec la ou une des piste(s) conductrice(s) ménagée(s) dans la première face 51A du circuit de pilotage 74. En variante non représentée, la première partie d'extrémité 82 peut être reliée électriquement à la ou une des piste(s) conductrice(s) du circuit de pilotage 74 via des connexions électriques internes au circuit ou via un connecteur déformable sous pression. La deuxième partie d'extrémité 84 débouche du côté de la deuxième face 51B du circuit de pilotage 74.

La deuxième partie d'extrémité 84 est connectée au composant électronique 16B, pour l'alimentation électrique du composant 16B, comme illustré sur les figures 8 et 9.

Le substrat 72 est en matériau conducteur thermiquement, par exemple en aluminium. Le substrat 72 comprend deux faces opposées 86A, 86B ; et un orifice 44 reliant les deux faces 86A, 86B.

La source lumineuse 16A est formée par une diode électroluminescente et est montée sur une première face 86A du substrat 72. Dans l'exemple de réalisation particulier des figures 7 à 9, la source lumineuse 16A est fixée directement sur cette première face 86A du substrat 72, par exemple par collage ou par soudure. La source lumineuse 16A est par exemple fixée sur un rebord latéral 88 de la première face 86A du substrat 72.

Le composant électronique 16B est monté sur une deuxième face 86B du substrat 72, opposée à la première face 86A. De préférence, le composant électronique 16B est fixé directement sur la deuxième face 86B du substrat 72, par exemple par collage ou par soudure.

Le substrat 72 définit sur sa première face 86A un rebord latéral 88 de support de la source lumineuse 16A, ainsi qu'un évidement 79. L'évidement 79 s'étend latéralement le long du rebord latéral 88, et longitudinalement selon la direction principale d'émission du faisceau lumineux. Comme illustré sur les figures 7 et 9, le circuit de pilotage 74 est reçu dans l'évidement 79, de sorte que la première face 51A du circuit de pilotage 74 et la face supérieure du rebord latéral 88 affleurent. Ainsi, un bord latéral 90 de la première face 51A du circuit de pilotage 74 s'étend en vis-à-vis de la source lumineuse 16A, comme illustré sur la figure 7.

Le dispositif d'alimentation 71 selon le mode de réalisation particulier représenté aux figures 7 à 9 permet de réduire la taille de l'insert 76. Ainsi, les coûts de fabrication de l'insert 76 sont avantageusement réduits.

Selon un mode de réalisation non représenté sur les figures, le dispositif lumineux 10 de véhicule ne comporte pas de module d'éclairage 12, mais comprend le support 14 de source(s) lumineuse(s). Selon ce mode de réalisation, le support 14 de source(s) lumineuse(s) est par exemple un support de signalisation lumineuse pour véhicule automobile, et le dispositif lumineux 10 est par exemple un feu de signalisation d'un véhicule, ou encore un module de signalisation lumineuse agencé sur ou au sein d'un véhicule.

En outre, bien que l'invention ait été décrite en référence à un support 14 de source(s) lumineuse(s) comprenant un composant électronique 16B de type diode électroluminescente, on comprendra bien entendu que l'invention n'est pas limitée à ce type de composant électronique, mais s'applique également à tout type de composant électronique apte à être alimenté par un courant électrique, par exemple à un module de pilotage du courant circulant au sein de la source lumineuse 16A.

## Revendications

1. Dispositif d'alimentation électrique (40, 71) adapté pour alimenter au moins une source lumineuse (16A) du type diode électroluminescente et au moins un composant électronique, (16B), comprenant:
- un circuit de pilotage (46, 74) de l'alimentation électrique de la ou chaque source lumineuse, (16A), le circuit de pilotage (46, 74) comprenant au moins une piste conductrice électriquement et un logement de réception (50, 78) d'un insert :
- un insert (48, 76) en matériau conducteur électriquement, ledit insert étant inséré dans le logement de réception (50, 78) et comprenant une première partie d'extrémité (53, 82) connectée électriquement à la piste conductrice, et une deuxième partie d'extrémité (54, 84) propre à être connectée électriquement à au moins un composant électronique, (16B), pour l'alimentation électrique dudit composant électronique, (16B), et dans lequel le circuit de pilotage (46, 74) comprend une première face, (51A), une deuxième face (51B) opposée à la première face (51A) et une ouverture (52) reliant les première et deuxième faces et formant ledit logement de réception, la piste conductrice électriquement étant agencée sur la première face (51A) ; l'insert (48, 76) s'étendant au travers de l'ouverture (52) ; la première partie d'extrémité (53, 82) de l'insert (48, 76) débouchant du côté de la première face, (51A), et la deuxième partie d'extrémité (54, 84) débouchant du côté de la deuxième face (51B) **caractérisé en ce que** l'insert (48, 76) est formé d'au moins une branche (49A, 49B) présentant une forme en « T », la première partie d'extrémité (53, 82) forme la barre la plus courte de la ou chaque branche en « T » et s'étend sur la première face (51A) du circuit de pilotage et la première partie d'extrémité (53, 82) est en cuivre, en étain, ou en aluminium ; ou encore dans un alliage comprenant au moins deux matériaux parmi le cuivre, l'étain et l'aluminium, la deuxième partie d'extrémité (54, 84) forme l'extrémité libre de la barre la plus longue de la ou chaque branche en « T » et la deuxième partie d'extrémité (54, 84) est en nickel, en alliage nickel-or ou nickel-palladium.

2. Dispositif d'alimentation électrique selon la revendication 1, dans lequel la première partie d'extrémité (53, 82) de l'insert (48, 76) est fixée par soudure sur la première face (51A) du circuit de pilotage.

3. Dispositif d'alimentation électrique selon la revendication 1, dans lequel l'insert (48, 76) est une pièce mécanique retenue par friction dans le logement de réception (50, 78) du circuit de pilotage.

4. Support (14) de source(s) lumineuse(s) pour module d'éclairage et/ou de signalisation lumineuse pour véhicule automobile, comprenant :
- un substrat (24, 72) en matériau conducteur thermiquement, le substrat comprenant deux faces opposées et un orifice (44, 64) reliant les deux faces ;
- au moins une source lumineuse (16A) du type diode électroluminescente montée sur une première face du substrat ;
- au moins un composant électronique (16B) monté sur une deuxième face du substrat, opposée à la première face ;
- un dispositif d'alimentation électrique (40, 71) de la ou de chaque source lumineuse et du ou de chaque composant électronique ; dans lequel le dispositif d'alimentation électrique est conforme à l'une quelconque des revendications précédentes, le circuit de pilotage (46, 74) du dispositif étant agencé sur la première face du substrat de sorte à ce que le logement de réception (50, 78) du circuit de pilotage s'étende en regard de l'orifice, (44, 64), l'insert (48, 76) du dispositif s'étendant au travers de l'orifice, (44, 64), la ou chaque source lumineuse (16A) étant connectée à la ou une des piste(s) conductrice(s) du circuit de pilotage, le ou chaque composant électronique (16B) étant connecté à la deuxième partie d'extrémité (54, 84) de l'insert.

5. Support selon la revendication 4, dans lequel le ou chaque composant électronique (16B) est un module de pilotage du courant au sein de la ou d'une des source(s) lumineuse(s).

6. Support selon la revendication 4, dans lequel le ou chaque composant électronique (16B) est une source lumineuse du type diode électroluminescente,

7. Support selon l'une quelconque des revendications 4 à 6, dans lequel la ou chaque source lumineuse (16A) est collée ou soudée sur la première face du substrat.

8. Support selon l'une quelconque des revendications 4 à 7 lorsque le dispositif d'alimentation électrique (40, 71) dépend de la revendication 1, dans lequel le substrat (24, 72) et le circuit de pilotage (46, 74) forment un seul et même composant de type substrat métallique isolé.

9. Module d'éclairage (12) pour véhicule automobile, comprenant :
- un support (14) de source(s) lumineuse(s) ;
- au moins un dispositif optique (18) apte à transmettre les rayons lumineux émis par la ou au moins une des sources lumineuses (16A) en un faisceau d'éclairage ; dans lequel le support (14) est conforme à l'une des revendications 4 à 8.

10. Module d'éclairage selon la revendication 9, le module comprenant un premier dispositif optique (18A) disposé en regard de la première face du substrat, (24, 72), et un deuxième dispositif optique (18B) disposé en regard de la deuxième face du substrat.

11. Module d'éclairage selon la revendication 9 ou 10, dans lequel le substrat (24, 72) comprend des ailettes de refroidissement (26) disposées en arrière du ou des dispositif(s) optique(s) (18, 18A, 18B) par rapport à la direction principale d'émission du faisceau d'éclairage.

12. Dispositif lumineux (10) de véhicule comprenant un support (14) de source(s) lumineuse(s) selon l'une quelconque des revendications 4 à 8 et/ou un module d'éclairage (12) selon l'une quelconque des revendications 9 à 11.

## Patentansprüche

1. Stromversorgungsvorrichtung (40, 71), die geeignet ist, mindestens eine Lichtquelle (16A) der Art Elektrolumineszenzdiode und mindestens ein elektronisches Bauteil (16B) zu versorgen, die enthält:
- eine Steuerschaltung (46, 74) der Stromversorgung der oder jeder Lichtquelle (16A), wobei die Steuerschaltung (46, 74) mindestens eine elektrische Leiterbahn und einen Aufnahmesitz (50, 78) eines Einsatzes enthält;
- einen Einsatz (48, 76) aus elektrisch leitendem Material, wobei der Einsatz in den Aufnahmesitz (50, 78) eingesetzt wird und einen ersten Endbereich (53, 82), der elektrisch mit der Leiterbahn verbunden ist, und einen zweiten Endbereich (54, 84) enthält, der geeignet ist, elektrisch mit mindestens einem elektronischen Bauteil (16B) zur Stromversorgung des elektronischen Bauteils (16B) verbunden zu werden,
und wobei die Steuerschaltung (46, 74) eine erste Seite (51A), eine zweite Seite (51B) gegenüber der ersten Seite (51A) und eine Öffnung (52) enthält, die die erste und zweite Seite verbindet und den Aufnahmesitz bildet, wobei die elektrische Leiterbahn auf der ersten Seite (51A) angeordnet ist; wobei der Einsatz (48, 76) sich durch die Öffnung (52) hindurch erstreckt; wobei der erste Endbereich (53, 82) des Einsatzes (48, 76) auf der Seite der ersten Seite (51A) mündet, und wobei der zweite Endbereich (54, 84) auf der Seite der zweiten Seite (51B) mündet;
**dadurch gekennzeichnet, dass** der Einsatz (48, 76) von mindestens einem Zweig (49A, 49B) gebildet wird, der eine T-Form aufweist, wobei der erste Endbereich (53, 82) den kürzeren Balken des oder jedes T-förmigen Zweigs bildet und sich auf der ersten Seite (51A) der Steuerschaltung erstreckt, und der erste Endbereich (53, 82) aus Kupfer, Zinn oder Aluminium oder auch aus einer Legierung ist, die mindestens zwei Materialien von Kupfer, Zinn und Aluminium enthält, der zweite Endbereich (54,84) das freie Ende des längeren Balkens des oder jedes T-förmigen Zweigs bildet, und der zweite Endbereich (54, 84) aus Nickel, einer Nickel-Gold-Legierung oder Nickel-Palladium-Legierung ist.

2. Stromversorgungsvorrichtung nach Anspruch 1, wobei der erste Endbereich (53, 82) des Einsatzes (48, 76) durch Schweißen auf der ersten Seite (51A) der Steuerschaltung befestigt wird.

3. Stromversorgungsvorrichtung nach Anspruch 1, wobei der Einsatz (48, 76) ein mechanisches Bauteil ist, das durch Reibung im Aufnahmesitz (50, 78) der Steuerschaltung gehalten wird.

4. Lichtquelle(n)-Träger (14) für ein Beleuchtungs- und/oder Leuchtsignalmodul für ein Kraftfahrzeug, der enthält:
- eine Trägerplatte (24, 72) aus wärmeleitendem Material, wobei die Trägerplatte zwei gegenüberliegende Seiten und eine die beiden Seiten verbindende Öffnung (44, 64) enthält;
- mindestens eine Lichtquelle (16A) der Art Elektrolumineszenzdiode, die auf eine erste Seite der Trägerplatte montiert ist;
- mindestens ein elektronisches Bauteil (16B), das auf eine zweite Seite der Trägerplatte gegenüber der ersten Seite montiert ist;
- eine Stromversorgungsvorrichtung (40, 71) der oder jeder Lichtquelle und des oder jedes elektronischen Bauteils;
wobei die Stromversorgungsvorrichtung gemäß einem der vorhergehenden Ansprüche ist, wobei die Steuerschaltung (46, 74) der Vorrichtung auf der ersten Seite der Trägerplatte angeordnet ist, so dass der Aufnahmesitz (50, 78) der Steuerschaltung sich gegenüber der Öffnung (44, 64) erstreckt; wobei der Einsatz (48, 76) der Vorrichtung sich durch die Öffnung (44, 64) hindurch erstreckt, wobei die oder jede Lichtquelle (164) mit der oder einer der Leiterbahnen der Steuerschaltung verbunden ist, wobei das oder jedes elektronische Bauteil (16B) mit dem zweiten Endbereich (54, 84) des Einsatzes verbunden ist.

5. Träger nach Anspruch 4, wobei das oder jedes elektronische Bauteil (16B) ein Steuermodul des Stroms innerhalb der oder einer der Lichtquelle(n) ist.

6. Träger nach Anspruch 4, wobei das oder jedes elektronische Bauteil (16B) eine Lichtquelle der Art Elektrolumineszenzdiode ist.

7. Träger nach einem der Ansprüche 4 bis 6, wobei die oder jede Lichtquelle (16A) auf die erste Seite der Trägerplatte geklebt oder geschweißt wird.

8. Träger nach einem der Ansprüche 4 bis 7, wenn die Stromversorgungsvorrichtung (40, 71) von Anspruch 1 abhängt, wobei die Trägerplatte (24, 72) und die Steuerschaltung (46, 74) ein und dasselbe Bauteil der Art isolierte metallische Trägerplatte bilden.

9. Beleuchtungsmodul (12) für ein Kraftfahrzeug, das enthält:
- einen Lichtquelle(n)-Träger (14);
- mindestens eine optische Vorrichtung (18), die geeignet ist, die von der oder mindestens einer der Lichtquellen (16A) emittierten Lichtstrahlen in einem Beleuchtungsbündel zu übertragen;
wobei der Träger (14) gemäß einem der Ansprüche 4 bis 8 ist.

10. Beleuchtungsmodul nach Anspruch 9, wobei das Modul eine erste optische Vorrichtung (18A), die gegenüber der ersten Seite der Trägerplatte (24, 72) angeordnet ist, und eine zweite optische Vorrichtung (18B) enthält, die gegenüber der zweiten Seite der Trägerplatte angeordnet ist.

11. Beleuchtungsmodul nach Anspruch 9 oder 10, wobei die Trägerplatte (24, 72) Kühlrippen (26) enthält, die hinter der oder den optischen Vorrichtungen (18, 18A, 18B) bezüglich der Hauptemissionsrichtung des Beleuchtungsbündels angeordnet sind.

12. Leuchtvorrichtung (10) eines Fahrzeugs, die einen Lichtquelle(n)-Träger (14) nach einem der Ansprüche 4 bis 8 und/oder ein Beleuchtungsmodul (12) nach einem der Ansprüche 9 bis 11 enthält.

## Claims

1. Electrical power supply device (40, 71) designed to supply power to at least one light source (16A) of the light-emitting diode type and at least one electronic component (16B), comprising:
- a circuit (46, 74) for driving the electrical power supply of the or each light source (16A), the drive circuit (46, 74) comprising at least one electrical conductor track and a housing (50, 78) for accommodating an insert;
- an insert (48, 76) in an electrically conducting material, said insert being inserted in the accommodation housing (50, 78) and comprising a first end portion (53, 82) electrically connected to the conductor track, and a second end portion (54, 84) suited to being electrically connected to at least one electronic component (16B), so as to supply electrical power to said electronic component (16B),
and wherein the drive circuit (46, 74) comprises a first face (51A), a second face (51B) opposite the first face (51A) and an opening (52) connecting the first and second faces and forming said accommodation housing, the electrical conductor track being arranged on the first face (51A); the insert (48, 76) extending through the opening (52); the first end portion (53, 82) of the insert (48, 76) coming out towards the first face (51A), and the second end portion (54, 84) coming out towards the second face (51B);
**characterized in that** the insert (48, 76) is composed of at least one branch (49A, 49B) having a T shape, the first end portion (53, 82) forms the shorter bar of the or each T-shaped branch and extends on the first face (51A) of the drive circuit and the first end portion (53, 82) is in copper, tin or aluminium; or indeed in an alloy comprising at least two materials among copper, tin and aluminium, the second end portion (54, 84) forms the free end of the longer bar of the or each T-shaped branch and the second end portion (54, 84) is in nickel, nickel-gold or nickel-palladium alloy.

2. Electrical power supply device according to Claim 1, wherein the first end portion (53, 82) of the insert (48, 76) is fastened by soldering to the first face (51A) of the drive circuit.

3. Electrical power supply device according to Claim 1, wherein the insert (48, 76) is a mechanical part held by friction in the accommodation housing (50, 78) of the drive circuit.

4. Light source(s) support (14) for light module and/or light-signalling module for motor vehicle, comprising:
- a substrate (24, 72) in heat-conducting material, the substrate comprising two opposite faces and an orifice (44, 64) connecting the two faces;
- at least one light source (16A) of the light-emitting diode type assembled on a first face of the substrate;
- at least one electronic component (16B) assembled on a second face of the substrate, opposite the first face;
- a power supply device (40, 71) for the or each light source and for the or each electronic component;
wherein the electrical power supply device conforms to any one of the preceding claims, the drive circuit (46, 74) of the device being arranged on the first face of the substrate such that the accommodation housing (50, 78) for the drive circuit extends facing the orifice (44, 64), the insert (48, 76) of the device extending through the orifice (44, 64), the or each light source (16A) being connected to the or one of the conductor tracks of the drive circuit, the or each electronic component (16B) being connected to the second end portion (54, 84) of the insert.

5. Support according to Claim 4, wherein the or each electronic component (16B) is a module for driving the current inside the or one of the light sources.

6. Support according to Claim 4, wherein the or each electronic component (16B) is a light source of the light-emitting diode type.

7. Support according to any one of Claims 4 to 6, wherein the or each light source (16A) is bonded or soldered on the first face of the substrate.

8. Support according to any one of Claims 4 to 7, when the electrical power supply device (40, 71) is dependent upon Claim 1, wherein the substrate (24, 72) and the drive circuit (46, 74) form a single component of the insulated metal substrate type.

9. Light module (12) for motor vehicle, comprising:
- a light source(s) support (14);
- at least one optical device (18) able to transmit the light rays emitted by the or at least one of the light sources (16A) as a lighting beam;
wherein the support (14) conforms to one of Claims 4 to 8.

10. Light module according to Claim 9, the module comprising a first optical device (18A) disposed facing the first face of the substrate (24, 72), and a second optical device (18B) disposed facing the second face of the substrate.

11. Light module according to Claim 9 or 10, wherein the substrate (24, 72) comprises cooling fins (26) disposed rearwards of the optical device(s) (18, 18A, 18B) relative to the main direction of emission of the lighting beam.

12. Vehicle light device (10) comprising a light source(s) support (14) according to any one of Claims 4 to 8 and/or a light module (12) according to any one of Claims 9 to 11.
